(19) **Europäisches Patentamt European Patent Office Office européen des brevets**

(11) **EP 2 089 724 B1**

(12) **FASCICULE DE BREVET EUROPEEN**

(45) Date de publication et mention de la délivrance du brevet:
**30.06.2010 Bulletin 2010/26**

(21) Numéro de dépôt: **07858714.4**

(22) Date de dépôt: **19.11.2007**

(51) Int Cl.:
*G01R 11/24* (2006.01)      *G01R 15/18* (2006.01)
*G01R 22/10* (2006.01)

(86) Numéro de dépôt international:
**PCT/FR2007/052361**

(87) Numéro de publication internationale:
**WO 2008/065291 (05.06.2008 Gazette 2008/23)**

(54) **COMPTEUR D'ENERGIE ELECTRIQUE COMPRENANT AU MOINS UN CAPTEUR DE MESURE DE COURANT DE TYPE INDUCTIF, ET CAPTEUR ASSOCIE**

MESSGERÄT FÜR ELEKTRISCHE ENERGIE MIT MINDESTENS EINEM INDUKTIVEN STROMSENSOR UND ENTSPRECHENDER SENSOR

ELECTRICAL ENERGY METER COMPRISING AT LEAST ONE INDUCTIVE TYPE CURRENT SENSOR, AND ASSOCIATED SENSOR

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **30.11.2006 FR 0655197**

(43) Date de publication de la demande:
**19.08.2009 Bulletin 2009/34**

(73) Titulaire: **Actaris SAS**
**92100 Boulogne Billancourt (FR)**

(72) Inventeurs:
• **TISSIER, Jean-François**
**86360 Chasseneuil Du Poitou (FR)**

• **FICHEN, Yvon**
**75014 Paris (FR)**

(74) Mandataire: **Hervouet, Sylvie et al**
**Feray Lenne Conseil**
**Le Centralis**
**63, avenue du Général Leclerc**
**92340 Bourg-la-Reine (FR)**

(56) Documents cités:
**WO-A-98/14759      GB-A- 2 391 948**
**GB-A- 2 409 528**

**Description**

La présente invention concerne un compteur d'énergie électrique comprenant au moins un capteur de mesure de courant alternatif de type inductif, ainsi qu'un capteur de mesure de courant de type inductif associé.

Les capteurs de mesure de courant alternatif sont classiquement utilisés dans les compteurs de consommation électrique à usage industriel ou résidentiel. Plus précisément, un capteur est associé à chaque phase du compteur. Ainsi, dans le cas d'un compteur monophasé, un seul capteur est utilisé, alors que dans le cas d'un compteur triphasé, trois capteurs de mesure sont utilisés pour permettre la mesure du courant dans chaque phase.

De tels capteurs sont de réalisation difficile car ils requièrent une grande immunité aux contraintes d'environnement, qu'elles soient de type thermodynamique (température, pression, humidité) ou électromagnétique (champs électriques et magnétiques).

Le capteur de mesure de courant doit en outre avoir une linéarité et une précision sur une large dynamique de courant et sur une large bande passante fréquentielle, l'onde de courant mesurée pouvant contenir de nombreux rangs harmoniques (fondamental = 50/60 Hz , harmoniques jusqu'au rang 21).

Aujourd'hui, les solutions classiques pour de tels capteurs peuvent être regroupées en quatre grandes familles:

- les capteurs passifs de type résistif (shunt),
- les transformateurs de courant,
- les capteurs inductifs,
- les capteurs actifs de type à Effet Hall ou capteurs de champ magnétique.

Le principe physique utilisé par le capteur de courant conditionne son immunité aux paramètres d'environnement, et détermine notamment les moyens de fraude qui peuvent être appliqués au compteur pour falsifier la mesure de courant, et par suite, la comptabilisation de l'énergie électrique consommée.

Par exemple, un capteur résistif de type shunt, basé sur la loi d'Ohm, est insensible par principe aux champs magnétiques continus, et faiblement sensible aux champs magnétiques alternatifs. Par contre, il présente une mauvaise stabilité en température.

On connaît en outre du document FR 2 800 167 un capteur de mesure de courant de type inductif, comportant un conducteur primaire linéaire en cuivre en forme de U, destiné à porter le courant alternatif à mesurer, ainsi qu'un bobinage disposé à l'intérieur du U, formant circuit secondaire. Le principe de la mesure de courant est ainsi basé sur un couplage magnétique dans l'air entre le circuit primaire qui est une phase du réseau sur lequel est placé le compteur d'électricité et du circuit secondaire galvaniquement isolé du circuit primaire. Un élément de blindage en matériau à forte perméabilité magnétique (de type alliage fer-nickel) entoure l'ensemble.

Un tel capteur inductif, grâce à l'élément de blindage de forte perméabilité magnétique (supérieure à 100000), aura une très bonne immunité aux champs magnétiques alternatifs externes et, dans le cas d'un compteur électrique multi phases nécessitant un capteur par phase, une très bonne réjection des influences magnétiques interphases internes au compteur. En revanche, les matériaux à forte perméabilité magnétique utilisés présentent des inductions de saturation assez basses, typiquement de l'ordre de 0,7 T pour un alliage de type fer-nickel ayant une teneur en nickel de 80% (type mumétal). En conséquence, ce même capteur inductif aura une faible immunité aux champs magnétiques continus, notamment ceux qui sont produits par des aimants permanents de forte puissance qui pourraient être utilisés par un fraudeur. En effet, la saturation du blindage par un aimant permanent entraînera dans tous les cas une réduction de la mutuelle inductance entre le circuit primaire et la bobine formant circuit secondaire, ce qui se traduira par une mesure de courant plus faible que le courant réellement consommé.

Une solution connue pour immuniser le capteur de mesure de courant de type inductif précédent consiste à utiliser un blindage supplémentaire entourant l'élément de blindage, ce blindage supplémentaire étant en un matériau ferromagnétique présentant une valeur élevée d'induction de saturation (typiquement supérieure à 2 T). Pour un compteur triphasé, ce blindage consiste en une unique pièce ferromagnétique en fer doux entourant complètement les trois capteurs de mesure de courant relatifs aux trois phases.

Les dimensions (taille et l'épaisseur) de cette pièce peuvent être très importantes lorsqu'il s'agit de contrer la fraude par certains types d'aimants présentant des surfaces polaires de grandes dimensions (50 x 50mm) et dont les inductions rémanentes sont de l'ordre de 1,2T.

Cette solution anti-fraude est cependant incompatible avec la tendance actuelle qui consiste à réduire l'encombrement des compteurs. En effet la réduction des volumes des compteurs d'électricité conduit à réduire les distances entre les faces externes de ces compteurs et les éléments de blindage des capteurs. Typiquement les distances minimales sont de l'ordre de 15 mm sur les faces latérales et entre 10 et 15 mm à l'arrière du compteur. Or, ces distances réduites imposent d'augmenter l'épaisseur du blindage supplémentaire en fer doux. La taille et le poids de la pièce de blindage en fer doux deviennent ainsi trop importants pour une utilisation en grande série au sein d'un compteur d'électricité.

On connaît du document GB 2 409 528 un compteur d'énergie électrique comportant au moins un capteur de mesure de courant du type inductif comprenant un circuit primaire destiné à être parcouru par un courant alternatif à mesurer, un circuit secondaire couplé magnétiquement dans l'air au circuit primaire, un élément de blindage pour l'isolation magnétique de l'ensemble formé par le circuit primaire et le circuit secondaire, et des moyens de mesure d'un état de saturation de l'élément de blindage lorsque le compteur d'énergie est en cours d'utilisation, de façon à détecter une fraude éventuelle par utilisation d'un aimant permanent. Dans ce document, le moyen de mesure est constitué d'un enroulement autour d'une portion de l'élément de blindage.

La présente invention a pour but de proposer une solution à faible encombrement, permettant de détecter toute tentative de fraude à l'aimant permanent sur un compteur à capteur de mesure de courant de type inductif.

Selon l'invention, les moyens de mesure comportent:

- au niveau du capteur inductif, un enroulement formant circuit tertiaire inséré entre le circuit secondaire et l'élément de blindage, et destiné à être parcouru par un courant d'injection alternatif de fréquence fixe et distincte des fréquences fondamentale et harmoniques du courant à mesurer;
- au niveau du compteur, des moyens générateurs pour délivrer ledit courant d'injection, des moyens de mesure d'une valeur représentative de la mutuelle inductance entre le circuit tertiaire et le circuit secondaire, et un moyen de comparaison de la valeur mesurée avec au moins une valeur de calibration, un état de saturation partielle ou totale de l'élément de blindage pouvant être déduit dès lors que la valeur mesurée est inférieure à la valeur de calibration.

Le courant d'injection utilisé a de préférence une forme d'onde triangulaire. Ainsi, cette forme d'onde de courant induit une tension carrée dans le circuit secondaire, et il est possible d'extraire la fréquence fondamentale du courant d'injection par détection synchrone.

De manière avantageuse, le moyen de comparaison de la valeur mesurée compare ladite valeur $M_2$ de la mutuelle inductance par rapport à deux valeurs limites mémorisées dans le compteur, une première valeur correspondant à la valeur de calibration représentative d'un état non saturé de l'élément de blindage, et une deuxième valeur correspondant à un état de saturation totale de l'élément de blindage.

Le moyen de comparaison peut alors générer un signal d'alerte dès lors que la valeur mesurée $M_2$ de la mutuelle inductance est située dans un intervalle prédéfini situé entre lesdites première et deuxième valeurs.

Dans le mode de réalisation préféré, le compteur comporte en outre un module de correction permettant de recalculer l'énergie totale réellement consommée par le compteur lorsqu'une fraude a été détectée, à partir de la mesure de la valeur représentative de la mutuelle inductance entre le circuit tertiaire et le circuit secondaire.

Un second objet de l'invention concerne un capteur de mesure de courant du type inductif comprenant un circuit primaire destiné à être parcouru par un courant alternatif à mesurer, un circuit secondaire couplé magnétiquement dans l'air au circuit primaire et un élément de blindage pour l'isolation magnétique de l'ensemble formé par le circuit primaire et le circuit secondaire, et un moyen de mesure d'un état de saturation de l'élément de blindage, de façon à détecter une fraude éventuelle par utilisation d'un aimant permanent, caractérisé en ce que ledit moyen de mesure comprend un enroulement formant circuit tertiaire inséré entre le circuit secondaire et l'élément de blindage, et destiné à être parcouru par un courant d'injection de fréquence fixe et distincte des fréquences fondamentale et harmoniques du courant à mesurer.

Avantageusement, le circuit tertiaire présente une forme similaire à celle du circuit primaire, de façon à obtenir d'une part une mutuelle inductance entre le circuit tertiaire et le circuit secondaire très proche de la mutuelle inductance entre le circuit primaire et le circuit secondaire, et d'autre part, une mutuelle inductance entre circuit primaire et circuit tertiaire négligeable. Ainsi, lorsque le capteur est utilisé dans un compteur, cette mutuelle inductance est négligeable quant à son influence métrologique à la fréquence du réseau.

Dans un premier mode de réalisation possible du capteur, le circuit primaire est un conducteur linéaire en forme générale de U, le circuit secondaire est une bobine multi spires centrée à l'intérieur du U, et le circuit tertiaire est une boucle ouverte formée par une piste conductrice continue en forme générale de U, certains tronçons de piste correspondant à une entrée et à une sortie du circuit tertiaire s'étendant dans un premier plan parallèle au plan du circuit primaire, au moins un tronçon s'étendant dans un second plan parallèle au premier plan et disposé symétriquement par rapport au plan du circuit primaire et symétriquement à l'intérieur de l'élément de blindage.

En variante, le circuit primaire est une bobine multi spires, le circuit tertiaire est une piste conductrice continue, certains tronçons de piste correspondant à une entrée et à une sortie du circuit tertiaire s'étendant dans un premier plan parallèle au plan du circuit primaire, au moins un tronçon s'étendant dans un second plan parallèle au premier plan et disposé symétriquement par rapport au plan du circuit primaire et symétriquement à l'intérieur de l'élément de blindage, les tronçons placés en regard de la bobine multi spires étant en outre en forme d'arc de cercle.

Dans les deux cas, cet agencement particulièrement optimisé dans deux plans symétriques par rapport au circuit primaire permet de détecter la fraude quel que soit le côté ou la face du capteur effectivement approchée et partiellement saturée par l'aimant.

Avantageusement, ledit circuit tertiaire est agencé à l'intérieur du capteur de sorte que l'entrée et la sortie du circuit tertiaire soient opposées à l'entrée et à la sortie du circuit primaire.

Dans le mode de réalisation préférée, la piste conductrice formant le circuit tertiaire est gravée sur un support de circuit imprimé flexible.

L'invention et les avantages qu'elle procure seront mieux compris au vu de la description suivante, faite en référence aux figures annexées dans lesquelles:

- les figures 1a à 1c illustrent deux perspectives assemblées et une perspective éclatée d'un capteur selon un premier mode de réalisation possible conforme à l'invention;
- la figure 2 illustre le circuit tertiaire du capteur selon le premier mode de réalisation;
- la figure 3 illustre schématiquement en plan l'association du circuit primaire et du circuit tertiaire du capteur selon le premier mode de réalisation;
- les figures 4a à 4c illustrent deux perspectives assemblées et une perspective éclatée d'un capteur selon un deuxième mode de réalisation possible conforme à l'invention;
- la figure 5 illustre le circuit tertiaire du capteur selon le deuxième mode de réalisation;
- la figure 6 illustre schématiquement l'association du circuit primaire et du circuit tertiaire du capteur selon le deuxième mode de réalisation;
- la figure 7 illustre, sous forme de synoptique de fonctionnement, un mode de réalisation préféré d'un compteur équipé d'un capteur de type inductif selon l'invention;
- la figure 8 illustre schématiquement un exemple de circuit interne d'un compteur triphasé, réalisant la circulation d'un même courant d'injection dans chacun des circuits tertiaires de trois capteurs de courant.

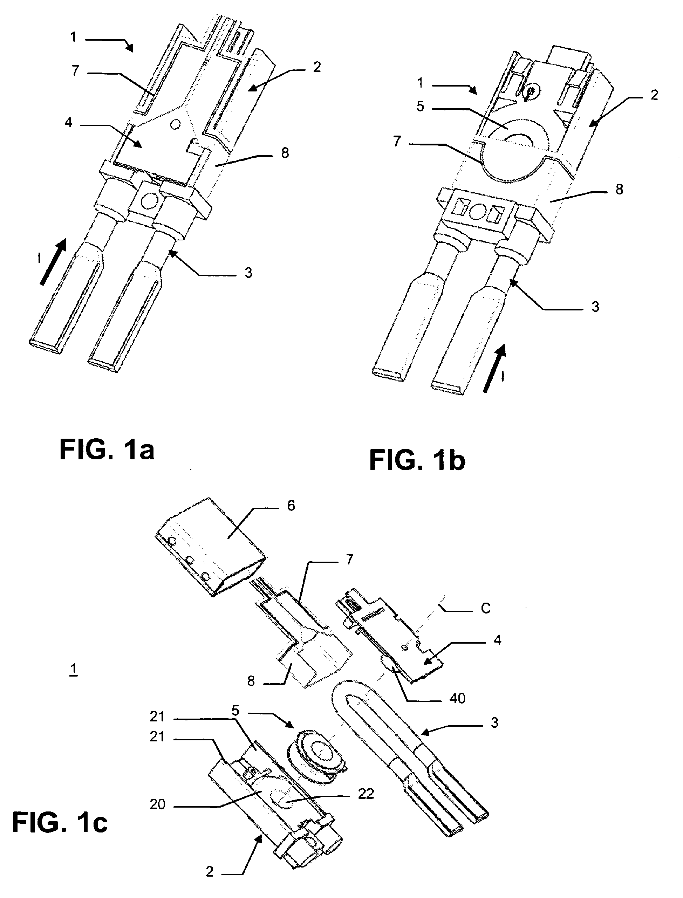

En référence aux figures 1a-1c, 2 et 3, un premier mode de réalisation d'un capteur 1 permettant la mise en oeuvre de l'invention va à présent être décrit. On notera que la figure 1c illustre une vue éclatée de ce capteur, alors que les figures 1a et 1b représentent deux perspectives assemblées, l'une vue de dessus, et l'autre de dessous, du capteur comportant tous les éléments de la figure 1c, à l'exception de l'élément de blindage, pour des raisons évidentes de clarté.

Le capteur 1 comprend une base 2 en matériau électriquement isolant, servant de logement pour recevoir en partie un premier conducteur linéaire 3 constituant un circuit dit primaire du capteur. Le premier conducteur 3 se présente sensiblement sous la forme d'un U, la base 2 étant par exemple surmoulée sur la base du U de façon à permettre une isolation électrique du circuit primaire. Les extrémités du U constituent quant à elles les bornes de connexion du capteur. Lorsque le capteur est connecté, un courant alternatif I à mesurer parcourt ainsi le circuit primaire 3. La base 2 est en outre formée de manière à recevoir et à coopérer avec un support d'élément sensible 4 en matériau également isolant.

Comme visible plus particulièrement sur la figure 1c, la base 2, globalement en forme de parallélépipède rectangle, présente une partie plane 20 délimitée de chaque côté par des rebords 21. La partie plane 20 présente un évidement 22 formant réceptacle et centré sur un axe central C. Le support d'élément sensible 4 présente quant à lui globalement une forme de plaque comportant sur une face un mandrin autour duquel vient se positionner coaxialement une bobine multi spires 40 formant le circuit secondaire du capteur. Dans l'exemple de réalisation représenté ici, l'évidement 22 formant réceptacle de la base 2 est cylindrique et apte à coopérer avec les rebords de la bobine 40 pour le centrage du circuit secondaire à l'intérieur du U du circuit primaire 3. Une pièce 5 placée dans l'évidement 22 forme élément d'isolation entre le circuit primaire 3 et le circuit secondaire 40.

L'ensemble des éléments 2 à 5 décrits ci-dessus est assemblé selon l'axe C et maintenu en place grâce à un élément de blindage 6 (figure 1c), en forme de parallélépipède, mis en place par coulissement sur les rebords 21 de la base 2. L'élément de blindage 6 est réalisé en un alliage ferromagnétique de type fer nickel dont la teneur en nickel est comprise en 50% et 80% de manière à garantir une perméabilité magnétique élevée.

Jusqu'ici, le capteur 1 ressemble en tout point au capteur inductif décrit dans le document FR 2 800 167 au nom du Demandeur.

La différence apportée par l'invention provient de l'ajout, dans le mode de réalisation préféré de l'invention, d'un élément supplémentaire au niveau du capteur, qui va permettre, comme cela va être expliqué dans la suite, de mesurer un état de saturation partielle ou totale de l'élément de blindage 6, caractéristique d'une tentative de fraude à l'aimant permanent.

Cet élément supplémentaire consiste en un enroulement formant circuit tertiaire 7, que l'on vient insérer entre le circuit secondaire 40 et l'élément de blindage 6.

Le circuit tertiaire 7 est destiné, lorsque le capteur 1 est notamment associé à une phase d'un compteur en cours d'utilisation conforme à l'invention, à être parcouru par un courant alternatif dit d'injection $I_{INJ}$ de faible amplitude (typiquement de l'ordre de 10 mA), et de fréquence $f_i$ fixe et distincte des fréquences fondamentale et harmoniques du courant à mesurer. Ce choix de fréquence $f_i$ est important si l'on veut être en mesure de distinguer, sur le circuit secondaire 40, les signaux induits par le passage du courant I à mesurer dans le circuit primaire 3, des signaux induits par le passage du courant d'injection $I_{INJ}$ dans le circuit tertiaire 7. On pourra être également amené à exclure, dans le choix de la fréquence $f_i$, d'autres fréquences, typiquement les fréquences utilisées dans des applications telles que la télécommande centralisée qui sont elles mêmes des fréquences inter harmoniques. Le choix de la fréquence $f_i$ peut être également contraint par la prise en compte de possibles variations de la fréquence fondamentale (50 ou 60Hz) et des harmoniques associés.

La géométrie et la position de ce circuit tertiaire 7 par rapport, d'une part, aux circuits primaire 3 et secondaire 40, et d'autre part, à l'élément de blindage 6, sont en outre de préférence optimisées pour répondre aux trois exigences suivantes:

- La mutuelle inductance entre le circuit tertiaire 7 et le circuit secondaire 40 doit être très proche de la mutuelle inductance entre le circuit primaire 3 et le circuit secondaire 40. Cette exigence est requise surtout dans le cas du compteur selon le mode de réalisation préféré qui réalise non seulement la détection de fraude, mais également la correction de l'énergie réellement consommée.
- les circuits respectivement primaire 3 et tertiaire 7 doivent influer le moins possible l'un sur l'autre, ce qui signifie en d'autres termes que la mutuelle inductance entre ces deux circuits doit être la plus faible possible pour être considérée comme négligeable. Ceci permet notamment d'éviter que la présence du circuit tertiaire ne vienne perturber la métrologie du compteur en réduisant la sensibilité du capteur 1;
- le circuit tertiaire 7 doit être réparti dans l'espace confiné à l'intérieur de l'élément de blindage 6, selon l'axe C du capteur, de façon à pouvoir détecter un état de saturation partielle du blindage quels que soient les faces ou les côtés de l'élément de blindage 6 effectivement approchés par l'aimant permanent lors d'une tentative de fraude.

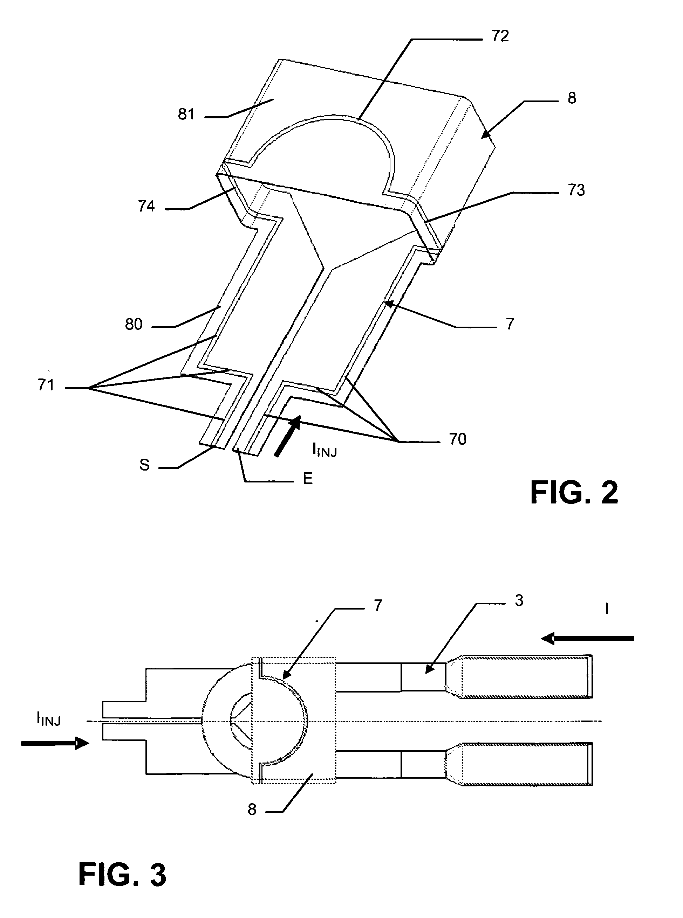

Un circuit tertiaire 7 répondant aux trois exigences précédentes est représenté sur les figures 1c, 2 et 3. Comme visible notamment sur les figures 2 et 3, le circuit tertiaire 7 est une piste conductrice formant une boucle ouverte. Certains tronçons de piste correspondant à une entrée E (tronçons 70 sur la figure 2) et à une sortie S (tronçons 71 sur la figure 2) du circuit tertiaire 7, s'étendent dans un premier plan 80 parallèle au plan du circuit primaire 3, et au moins un autre tronçon 72 de piste s'étend dans un second plan 81, parallèle au premier plan 80, et disposé à l'opposé du premier plan, de préférence symétriquement à ce premier plan 80 par rapport au circuit primaire 3. Les deux plans 80 et 81 se trouvent ainsi placés symétriquement dans l'espace confiné à l'intérieur de l'élément de blindage 6. Enfin, des tronçons latéraux 73, 74 relient les tronçons des deux plans 80 et 81 de manière à former une piste continue. A noter que, pour faciliter la compréhension, les tronçons de piste 70, 71 et 74 sont visibles par transparence sur la figure 2.

On remarque en outre que le tronçon 72 présente une forme arrondie choisie judicieusement similaire à la forme de la base du U du circuit primaire 3 (voir figure 3). Ainsi, le circuit tertiaire 7, projeté sur un plan, présente globalement la même forme que le circuit primaire 3, ce qui permet de répondre à deux premières exigences précitées relatives aux différentes mutuelles inductances. On répond par ailleurs à la troisième exigence précitée par la répartition des tronçons actifs du circuit tertiaire 7 dans les deux plans 80 et 81.

Dans le mode de réalisation préféré, le circuit tertiaire 7 est agencé dans le capteur 1 de sorte que son entrée E et sa sortie S soient opposées à celles du circuit primaire (voir figure 3). Cet agencement permet non seulement de faciliter la connectique du capteur à l'intérieur du compteur, mais aussi de garantir une bonne isolation galvanique entre ces deux circuits.

Le circuit tertiaire 7 est de préférence réalisé sous forme d'une piste conductrice gravée sur un support de circuit imprimé flexible 8. Ainsi, lors de l'assemblage des différents éléments du capteur, il est très facile de replier le support flexible 8 autour de l'ensemble formé par la base 2, le support d'élément sensible 4 et la bobine secondaire 40, de manière à ce qu'il présente la forme illustrée sur la figure 2. L'élément de blindage 6 est alors positionné par coulissement et maintient l'ensemble des éléments du capteur 1.

Le capteur 1 selon le premier mode de réalisation est particulièrement adapté pour la mesure de courants de forte amplitude (typiquement entre 10 mA à 100A). Ces capteurs sont utilisés sur des compteurs d'électricité placés sur des réseaux basse tension pour lesquels les phases du réseau traversent les compteurs.

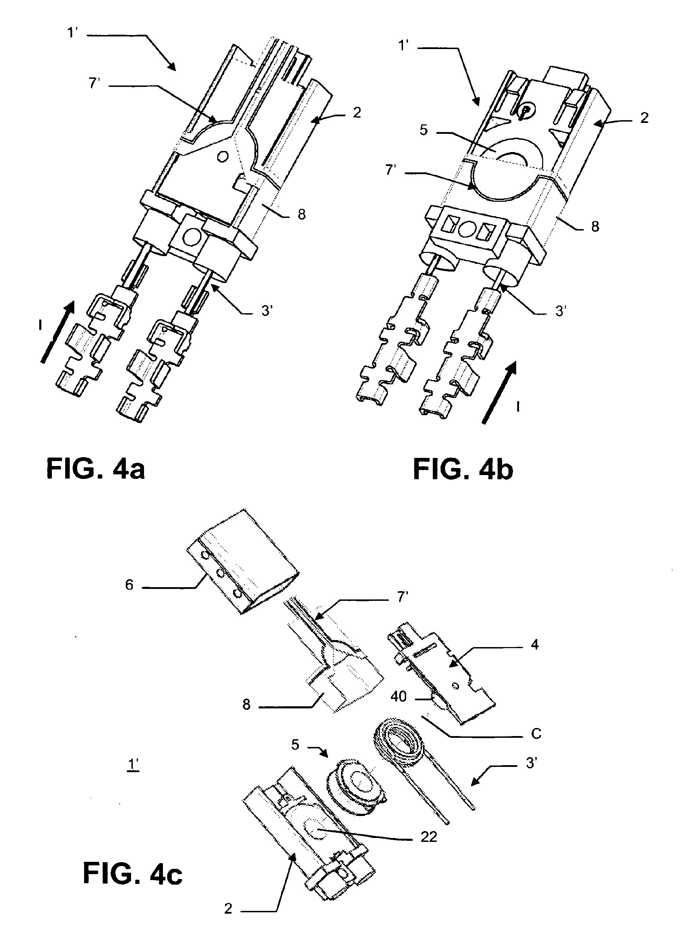

Les figures 4a-4c, 5 et 6 sont des représentations similaires aux figures précédemment décrites, à ceci près qu'elles représentent un deuxième mode de réalisation d'un capteur 1' conforme à l'invention, particulièrement adapté à la mesure de courant de faible amplitude (typiquement entre 1 mA à 10A). Ces capteurs sont utilisés sur des compteurs d'électricité placés sur des réseaux basse tension de forte puissance ou haute tension, réseau pour lesquels les capteurs de courants sont reliés à des transformateurs de courant abaisseurs.

Ce capteur 1' ne diffère du capteur 1 que dans la forme des circuits primaire et tertiaire. Les autres éléments sont inchangés, et portent de ce fait des références identiques à celles déjà décrites.

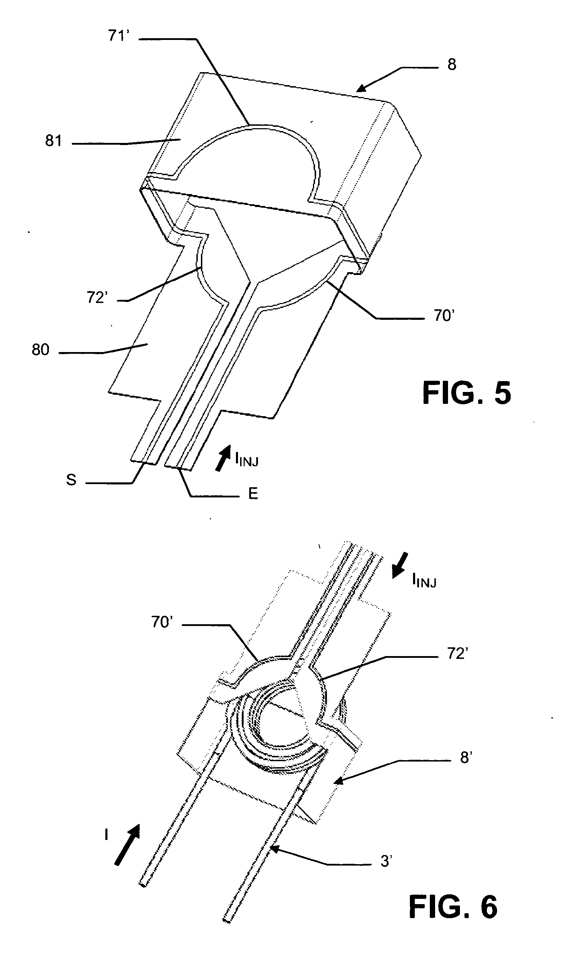

Le circuit primaire 3' du capteur 1' utilise un conducteur électrique de diamètre plus faible que le circuit primaire 3 du capteur 1, typiquement de l'ordre de 1,2 mm de diamètre. En conséquence, au lieu d'avoir une forme de simple U comme le circuit primaire 3 du capteur 1, le circuit primaire 3' présente ici sous la forme d'une bobine multi spires. La géométrie du circuit tertiaire 7' est de ce fait également différente, notamment par la présence de trois tronçons de piste 70', 71' et 72' (figure 5) placés en regard de la bobine multi spires en forme d'arc de cercle. Ici encore, les tronçons 70' et 71' sont rendus visibles par transparence sur la figure 5. Ainsi, projetés sur un plan, les trois tronçons 70', 71' et 72' forment une boucle circulaire placée en regard du circuit primaire. Ici encore, la similitude de forme des circuits primaire 3' et tertiaire 7' permet d'obtenir d'une part, une mutuelle inductance entre le circuit tertiaire 7' et le circuit secondaire 40 très proche de la mutuelle inductance entre le circuit primaire 3' et le circuit secondaire 40, et d'autre part une mutuelle inductance négligeable entre le circuit primaire 3' et le circuit tertiaire 7'.

Quel que soit le capteur 1 ou 1' utilisé, on va à présent décrire le principe de la détection de tentative de fraude par utilisation d'un aimant permanent.

Dans la suite, on appellera:

- $M_1$, la valeur de la mutuelle inductance entre les circuits primaires 3 ou 3' et secondaires 40;
- $M_2$, la valeur de la mutuelle inductance entre les circuits tertiaires 7 ou 7' et secondaires 40 ;
- $M_3$, la valeur de la mutuelle inductance entre les circuits primaires 3 ou 3' et tertiaires 7 ou 7'.

On notera par ailleurs, pour chacune des mutuelles $M_i$ (i étant un entier variant de 1 à 2):

- $M_{imax}$, la valeur maximale de la mutuelle inductance $M_i$, correspondant à un élément de blindage 6 dans un état normal, c'est-à-dire non saturé, même partiellement. Cette valeur, qui constitue ainsi une valeur de référence, est obtenue au moment de la calibration du compteur équipé du capteur, et est mémorisée dans le compteur.
- $M_{isat}$, la valeur de la mutuelle inductance $M_i$ lors d'une saturation totale de l'élément de blindage 6. Cette valeur est estimée par construction comme correspondant à la valeur de la mutuelle inductance sans élément de blindage 6, et elle est également mémorisée dans le compteur;
- $M_i(x)$, toute valeur de la mutuelle inductance $M_i$ correspondant à un état plus ou moins important de saturation de l'élément de blindage 6.

Ainsi, on a la relation suivante:

$$M_{isat} < M_i(x) < M_{imax}$$

traduisant le fait que toute tentative de fraude vient réduire plus ou moins les mutuelles inductance $M_1$ et $M_2$ consécutivement à l'augmentation de la réluctance des circuits magnétiques vue par les inductions magnétiques primaires et tertiaires.

Avec les précautions géométriques prises pour le circuit tertiaire, la mutuelle $M_3$ a par ailleurs une valeur très faible (inférieure à 5nH soit 1500 fois plus faible que la mutuelle $M_1$).

Une interpolation linéaire permet de relier la variation de la mutuelle inductance $M_1$ et la variation de la mutuelle inductance $M_2$. On peut ainsi démontrer que la loi de variation entre les mutuelles inductances $M_1$ et $M_2$ est la suivante:

$$(1) \qquad M_1(x) / M_{1max} = (1 + a) (M_2(x) / M_{2max}) - a$$

avec

$$a = ( (M_{2sat} / M_{2max}) - (M_{1sat} / M_{1max}) ) / ( 1 - (M_{2sat} / M_{2max}) )$$

Cette loi linéaire traduit le fait que si $M_2(x) = M_2max$, alors $M_1(x) = M_{1max}$, qui correspond à l'état standard (calibration) de l'élément de blindage et que si $M_2(x) = M_{2sat}$, alors $M_1(x) = M_{1sat}$, qui correspond à l'état totalement saturé de l'élément de blindage.

La connaissance de la variation de la mutuelle $M_2(x)$ par rapport à sa valeur de référence $M_{2max}$ va permettre au minimum de détecter un état de saturation partielle ou totale, de l'élément de blindage, caractéristique de la fraude par aimant permanent, voire de corriger par le calcul la valeur de la mutuelle $M_1(x)$ par rapport à sa valeur de référence, et en conséquence de compenser les valeurs du courant mesuré.

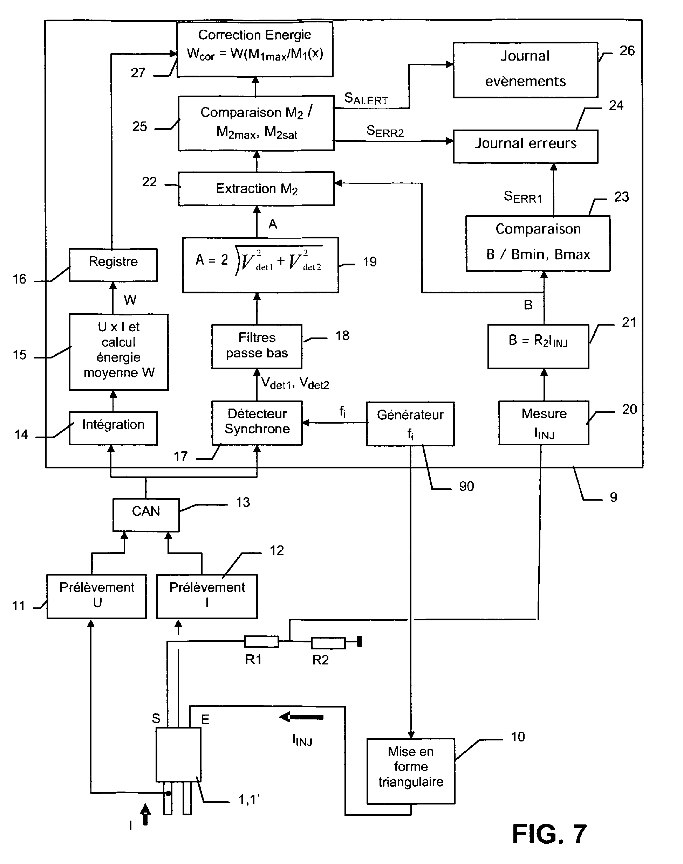

Le principe de la détection et de la correction va à présent être explicité en référence à la figure 7 qui illustre, sous forme de synoptique simplifié, les différents composants d'un compteur conforme à l'invention:

Sur ce synoptique, on retrouve un capteur 1 ou 1' tel que précédemment décrit, destiné à mesurer le courant alternatif I lisé à une phase du réseau sur lequel le compteur est connecté. Le compteur comporte en outre un microprocesseur 9 contrôlant les différents éléments du compteur. Le compteur comporte enfin, conformément à l'invention, des moyens de génération du courant d'injection alternatif $I_{INJ}$ à la fréquence $f_i$ fixe et distincte des fréquences utilisées par le réseau électrique. On choisira par exemple une fréquence $f_i$ égale à 327,23 Hz.

Le capteur étant de type inductif dérivateur, la forme d'onde du courant d'injection sera choisie de préférence triangulaire. Ainsi, la forme d'onde résultante en sortie du capteur sera un signal carré, et la mesure de la composante fondamentale à la fréquence $f_i$ pourra être faite avantageusement par une détection synchrone. Une telle forme d'onde du courant d'injection peut être obtenue par un générateur de fréquence 90 à la fréquence $f_i$, interne au microprocesseur 9 et contrôlé pour délivrer un signal carré de fréquence $f_i$ à un circuit 10 intégrateur du signal délivrant un signal de tension triangulaire à la fréquence $f_i$. Le courant d'injection est alors fixé par le rapport entre la tension délivrée par le circuit intégrateur 10 et la résistance de charge. En variante, on pourrait utiliser un oscillateur local pour délivrer le signal carré de fréquence $f_i$ au circuit intégrateur.

Le circuit tertiaire du capteur, symbolisé ici par son entrée E et sa sortie S, est placé dans une boucle de courant, en série entre la sortie du circuit 10 de mise en forme et deux résistances R1, R2 reliées à la masse, de sorte que ce circuit tertiaire est bien parcouru par le courant d'injection $I_{INJ}$ à la fréquence $f_i$.

Le compteur dispose en outre, de façon classique, de moyens 11 permettant de prélever la tension d'entrée U du capteur 1, 1', correspondant à la tension de la phase, et des moyens 12 pour prélever, à partir de la tension de sortie de ce capteur une tension représentative du courant I mesuré par le capteur 1, 1'. Les signaux de sortie des moyens 11 et 12 sont ensuite classiquement échantillonnés par un convertisseur analogique-numérique 13. Dans les deux cas, les moyens 11 et 12 sont des ponts diviseurs résistifs qui permettent en outre d'abaisser le niveau de tension à une valeur compatible avec le niveau d'entrée accepté par le convertisseur analogique-numérique 13.

Les échantillons vont ensuite subir deux voies de traitement en parallèle. Les différents traitements sont représentés à l'intérieur du microprocesseur 9 du fait qu'il s'agit, dans la mise en oeuvre préférée, de traitements de nature purement logicielle:

La première voie de traitement, la plus à gauche sur la figure 7, correspond à l'extraction classique de l'énergie consommée par le compteur sur la phase associée. Elle comporte en premier lieu un intégrateur numérique 14 qui va permettre de retrouver des échantillons images de signaux U et I. Cette intégration est rendue nécessaire de par l'utilisation du capteur inductif, par nature dérivateur des signaux. Les échantillons de tension et de courant en sortie de l'intégrateur numérique 14 sont ensuite multipliés deux à deux dans le module principal de métrologie, et l'énergie moyenne W consommée est calculée à partir des différents produits obtenus sur une durée donnée, par exemple d'une seconde. A noter que les échantillons de courant à la fréquence $f_i$ n'ont aucune participation au calcul de cette énergie moyenne puisqu'il n'y a aucun signal de tension à cette fréquence $f_i$. La puissance moyenne W est ensuite mémorisée dans un registre ou une mémoire 16 du compteur.

La deuxième voie de traitement, permettant selon la réalisation préférée de l'invention, de mesurer les variations de la mutuelle inductance $M_2$ suite à une détection synchrone, d'en déduire une fraude à l'aimant permanent et de corriger la mutuelle inductance $M_1$ de façon à pouvoir corriger la valeur de l'énergie effectivement consommée, va à présent être décrite:

Rappelons tout d'abord que le signal de sortie du capteur 1, 1' est la superposition de signaux à la fréquence du réseau (50/60Hz) et à ses harmoniques, et de signaux à la fréquence $f_i$ et à ses harmoniques. Un détecteur synchrone 17 réalise, à partir des échantillons délivrés par le convertisseur analogique-numérique 13, la multiplication du signal de sortie $V_S$ du capteur par un premier signal sinusoïdal et par un deuxième signal cosinusoïdal à la fréquence $f_i$, cette fréquence $f_i$ étant par ailleurs fournie par l'oscillateur 90. Par ces deux multiplications, on obtient en sortie du détecteur synchrone 17, deux signaux $V_{det1}$ et $V_{det2}$ tels que:

$$V_{det1} = V_S \sin(2\pi f_i t)$$

$$V_{det2} = V_S \cos(2\pi f_i t)$$

A noter que, dans le cas où un oscillateur local est utilisé à la place du générateur de fréquence 90, il sera nécessaire de recréer les signaux à la fréquence $f_i$.

Ces deux signaux $V_{det1}$ et $V_{det2}$ sont ensuite filtrés par des filtres passe bas 18 ayant une faible fréquence de coupure de façon à être en mesure d'éliminer l'amplitude de l'ondulation crée par la modulation entre la fréquence du courant généré sur le tertiaire et les composantes fréquentielles du courant sur le circuit primaire, et de ne délivrer que les valeurs continues des signaux $V_{det1}$ et $V_{det2}$.

Or, la composante fréquentielle en sortie du capteur 1, 1' à la fréquence $f_i$ peut également s'exprimer de la façon suivante:

$$V_S\ (f_i) = M_2\ I_i\ 2\pi\ f_i\ cos(2\pi f_i t - \varphi_1) = 2\sqrt{V_{det1}^2 + V_{det2}^2}\ cos(2\pi f_i t - \varphi_1)$$

relation dans laquelle $I_i$ est l'amplitude du courant d'injection $I_{INJ}$ dans le circuit tertiaire.

Ainsi, la connaissance des valeurs continues des signaux $V_{det1}$ et $V_{det2}$, de la fréquence $f_i$ du courant d'injection et de l'amplitude $I_i$ permet de déterminer la mutuelle inductance $M_2$ entre le circuit secondaire et le circuit tertiaire du capteur, selon la relation:

$$M_2 = \frac{2\sqrt{V_{det1}^2 + V_{det2}^2}}{2\pi\ I_i\ f_i} = \frac{A}{2\pi\ I_i\ f_i}\quad (2)$$

avec $A = 2\sqrt{V_{det1}^2 + V_{det2}^2}$

La valeur A est extraite d'un module de calcul 19 recevant les sorties des filtres passe-bas 18.

L'amplitude $I_i$ peut être un paramètre fixé et mémorisé par le compteur. Dans ce cas, la mutuelle inductance $M_2$ peut être directement déduite en application de la relation (2) ci-dessus.

En variante, et selon la réalisation préférée représentée sur le synoptique, le microprocesseur 9 du compteur effectue en temps réel une mesure de l'amplitude de la tension développée par le courant d'injection $I_{INJ}$ parcourant le circuit tertiaire à travers une résistance de référence, ici la résistance $R_2$. Ainsi, le compteur dispose, comme représenté sur le synoptique de la figure 7, d'un moyen 20 de mesure du courant d'injection prélevant la tension aux bornes de la résistance de référence $R_2$, et d'un moyen 21 d'extraction de l'amplitude B telle que

$$B = R_2 I_{INJ}$$

Dans ce cas, la valeur de la mutuelle inductance M2 est calculée par un module d'extraction 22 en appliquant la relation suivante:

$$M_2 = (A/B).(R_2/2\pi f_i)\quad (2bis)$$

L'intérêt d'effectuer une mesure en temps réel de l'amplitude de la tension développée par le courant d'injection $I_{INJ}$ réside dans le fait que l'on contrôle à tout moment la présence réelle d'un courant d'injection, sans lequel le principe de détection de fraude et de correction associée ne peut être appliqué. Aussi, dans la réalisation préférée, le compteur dispose en outre de moyens de comparaison 23 permettant de vérifier que la valeur extraite B est bien située entre deux limites respectivement inférieure $B_{min}$ et supérieure $B_{max}$ connues et préalablement mémorisées dans le compteur. Dans le cas contraire, le compteur sera susceptible de délivrer un signal d'erreur $S_{ERR1}$, indiquant notamment que la valeur extraite de $M_2$ ne doit pas être prise en compte. Ce signal d'erreur est par exemple mémorisé dans un journal d'erreurs 24.

Une fois que la mutuelle inductance $M_2$ a été extraite et validée comme expliqué précédemment, le compteur va pouvoir vérifier où se trouve cette valeur entre la valeur $M_{2max}$ caractéristique d'un élément de blindage non saturé, et la valeur $M_{2sat}$ caractéristique d'un élément de blindage totalement saturé. On rappelle que ces deux valeurs extrêmes résultent de la calibration du compteur, et ont préalablement été mémorisées dans le compteur.

Pour ce faire, le compteur dispose d'un moyen 25 de comparaison permettant de comparer la valeur $M_2$ avec une première limite supérieure, inférieure à $M_{2max}$ (par exemple égale à 0,97 $M_{2max}$), et une seconde limite inférieure, supérieure à $M_{2sat}$ (par exemple égale à 1,05 $M_{2sat}$). Le compteur peut ainsi déduire qu'il y a une tentative de fraude dès lors que la valeur mesurée de $M_2$ sera comprise dans l'intervalle situé entre cette limite inférieure et cette limite supérieure. De préférence, toute comparaison ne sera effectuée que si la mesure de $M_2$ reste stable pendant une certaine durée, par exemple de l'ordre de plusieurs secondes, de façon à tenir compte du temps de réponse des filtres passe-bas 18.

A ce stade, le moyen de comparaison 25 du compteur peut également vérifier que la valeur extraite de $M_2$ ne se situe pas au-deçà de la valeur $M_{2sat}$ ou au-delà de la valeur $M_{2max}$. Dans le cas contraire, il peut générer un signal d'erreur $S_{ERR2}$ mémorisé dans le journal d'erreurs 24.

Dans le cas où une tentative de fraude à l'aimant permanent est détectée au niveau du moyen de comparaison 25, ce dernier génère un signal d'alerte $S_{ALERT}$ à destination d'un journal 26 d'enregistrement des évènements et/ou vers un dispositif (non représenté) de type led ou écran d'affichage permettant de visualiser le signal d'alerte depuis l'extérieur du compteur.

En outre, dans la réalisation préférée, le compteur sera en mesure de corriger par lui-même la valeur d'énergie W mémorisée dans le registre 16, cette valeur étant, du fait de la fraude, inférieure à la valeur réelle.

Pour ce faire, et compte tenu de la relation (1) précédente permettant de déduire la valeur $M_1$ à partir de la mesure de $M_2$, un module 27 de correction recalcule l'énergie corrigée $W_{cor}$ en appliquant la relation suivante:

$$W_{cor} = W( M_{1max} / M_1(x) )$$

Cette énergie est la somme de l'énergie W calculée par la chaîne métrologique du compteur à laquelle est ajoutée l'énergie complémentaire déduite de la correction

$$W_{comp} = W( M_{1max} / M_1(x) -1 )$$

Soit

$$W_{cor} = W + W_{comp}$$

Le synoptique de la figure 7 ne comporte qu'un seul capteur 1 ou 1'. Bien entendu l'invention s'applique de la même manière dans le cas d'un compteur polyphasés comportant une pluralité de capteurs 1, 1', chacun associé à une phase du compteur. Ainsi, il est possible de détecter, voire corriger, une fraude à l'aimant permanent de façon indépendante sur chaque phase.

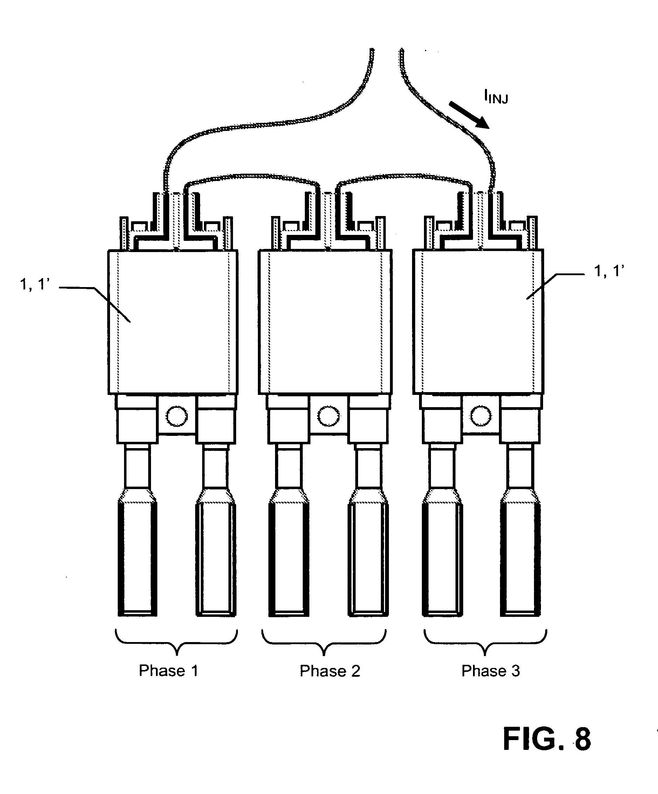

Dans ce cas néanmoins, on pourra avantageusement simplifier le compteur en prévoyant une seule boucle de courant d'injection au niveau du compteur, les circuits tertiaires de chaque capteur étant placés en série dans cette boucle de courant. Cette disposition assure une unicité de la valeur du courant d'injection dans chacun des circuits tertiaires; et en conséquence simplifie les calculs des mutuelles inductances $M_2$ pour chacun des capteurs de phase. La figure 8 illustre schématiquement trois capteurs de type 1 ou 1' utilisés dans un compteur triphasé, et dont les circuits tertiaires respectifs sont connectés en série dans la boucle de courant d'injection $I_{INJ}$.

Le capteur et le compteur selon l'invention permettent de conserver l'immunité aux champs magnétiques alternatifs externes conférée par l'élément de blindage tout en permettant un contrôle permanent de l'état de saturation partielle ou totale de cet élément de blindage lors d'une tentative de fraude à l'aimant permanent. Dans sa version préférée (synoptique de la figure 7), le compteur dispose en outre de moyens pour compenser les erreurs de mesure de courant résultant d'une telle fraude à l'aimant permanent. La géométrie et l'agencement du circuit tertiaire peut être en outre optimisée pour garantir une détection de la fraude quelle que soit la façon avec laquelle est approché l'aimant permanent.

**Revendications**

1.  Capteur (1 ; 1') de mesure de courant du type inductif comprenant un circuit primaire (3 ; 3') destiné à être parcouru par un courant alternatif à mesurer, un circuit secondaire (40) couplé magnétiquement dans l'air au circuit primaire (3 ; 3') et un élément de blindage (6) pour l'isolation magnétique de l'ensemble formé par le circuit primaire (3 ; 3') et le circuit secondaire (40), et un moyen (7 ; 7') de mesure d'un état de saturation de l'élément de blindage (6), de façon à détecter une fraude éventuelle par utilisation d'un aimant permanent, **caractérisé en ce que** ledit moyen de mesure comprend un enroulement formant circuit tertiaire (7 ; 7') inséré entre le circuit secondaire (40) et l'élément de blindage (6), et destiné à être parcouru par un courant d'injection ($I_{INJ}$) de fréquence ($f_i$) fixe et distincte des fréquences fondamentale et harmoniques du courant à mesurer.

2.  Capteur (1 ; 1') selon la revendication 1, **caractérisé en ce que** le circuit tertiaire (7 ; 7') présente une forme similaire à celle du circuit primaire (3 ; 3') de façon à obtenir d'une part, une mutuelle inductance ($M_2$) entre le circuit tertiaire (7 ; 7') et le circuit secondaire (40) très proche de la mutuelle inductance ($M_1$) entre le circuit primaire (3 ; 3') et le circuit secondaire (40), et d'autre part, une mutuelle inductance ($M_3$) entre circuit primaire (3 ; 3') et circuit tertiaire (7 ; 7') négligeable.

3.  Capteur (1) selon la revendication 2, **caractérisé en ce que** le circuit primaire (3) est un conducteur linéaire en forme générale de U, **en ce que** le circuit secondaire (40) est une bobine multi spires centrée à l'intérieur du U, et **en ce que** le circuit tertiaire (7) est une boucle ouverte formée par une piste conductrice continue en forme générale de U, certains tronçons (70, 71) de piste correspondant à une entrée (E) et à une sortie (S) du circuit tertiaire (7) s'étendant dans un premier plan (80) parallèle au plan du circuit primaire (3), au moins un tronçon (72) s'étendant dans un second plan (81) parallèle au premier plan et disposé symétriquement par rapport au plan du circuit primaire et symétriquement à l'intérieur de l'élément de blindage (6).

4.  Capteur (1') selon la revendication 2, **caractérisé en ce que** le circuit primaire (3') est une bobine multi spires, et **en ce que** le circuit tertiaire (7') est une piste conductrice continue, certains tronçons (70', 72') de piste correspondant à une entrée (E) et à une sortie (S) du circuit tertiaire (7') s'étendant dans un premier plan (80) parallèle au plan du circuit primaire (3'), au moins un tronçon (71') s'étendant dans un second plan (81) parallèle au premier plan et disposé symétriquement par rapport au plan du circuit primaire et symétriquement à l'intérieur de l'élément de blindage (6), les tronçons (70', 71', 72') placés en regard de la bobine multi spires étant en outre en forme d'arc de cercle.

5.  Capteur (1 ; 1') selon l'une quelconque des revendications 3 et 4, **caractérisé en ce que** ledit circuit tertiaire (7 ; 7') est agencé à l'intérieur du capteur (1 ; 1') de sorte que l'entrée (E) et la sortie (S) du circuit tertiaire (7 ; 7') soient opposées à l'entrée et à la sortie du circuit primaire (3 ; 3').

6.  Capteur (1 ; 1') selon l'une quelconque des revendications 3 à 5, **caractérisé en ce que** la piste conductrice formant le circuit tertiaire (7 ; 7') est gravée sur un support (8) de circuit imprimé flexible.

7.  Capteur (1 ; 1') selon l'une quelconque des revendications 1 à 6, **caractérisé en ce que** l'élément de blindage (6) sert de maintien pour les circuits primaire, secondaire et tertiaire du capteur.

8.  Compteur d'énergie électrique comportant au moins un capteur (1 ; 1') de mesure de courant du type inductif selon la revendication 1, **caractérisé en ce que** lesdits moyens de mesure comportent en outre, au niveau du compteur, des moyens générateurs (10, 90) pour délivrer ledit courant d'injection (IINJ), des moyens (17-19, 21, 22) de mesure d'une valeur représentative de la mutuelle inductance (M2) entre le circuit tertiaire (7 ; 7') et le circuit secondaire (40), et un moyen (25) de comparaison de la valeur mesurée avec au moins une valeur de calibration (M2max), un état de saturation partielle ou totale de l'élément de blindage pouvant être déduit dès lors que la valeur mesurée est inférieure à la valeur de calibration.

9.  Compteur selon la revendication 8, **caractérisé en ce que** les moyens générateurs (10, 90) délivrent un courant d'injection ($I_{INJ}$) de forme d'onde triangulaire, et **en ce que** des moyens (17-19, 21, 22) de mesure d'une valeur représentative de la mutuelle inductance ($M_2$) entre le circuit tertiaire (7 ; 7') et le circuit secondaire (40) comportent un détecteur synchrone (17) délivrant un premier signal ($V_{det1}$) et un deuxième signal ($V_{det2}$) résultant de la multiplication du signal de sortie (Vs) du capteur (1 ; 1') respectivement par un premier signal sinusoïdal et par un deuxième cosinusoïdal à la fréquence ($f_i$) du courant d'injection ($I_{INJ}$), et des moyens de filtrage (18) délivrant les valeurs continues desdits premier et deuxième signaux ($V_{det1}$, $V_{det2}$).

**10.** Compteur selon la revendication 9, **caractérisé en ce que** lesdits moyens (17-19, 21, 22) de mesure d'une valeur représentative de la mutuelle inductance ($M_2$) entre le circuit tertiaire (7 ; 7') et le circuit secondaire (40) comportent en outre un module (22) d'extraction calculant la valeur $M_2$ de ladite mutuelle selon la relation

$$M_2 = \frac{A}{2\pi I_i f_i}$$

dans laquelle :

- $f_i$ est la fréquence du courant d'injection ;

- A est une première variable telle que $A = 2\sqrt{V_{det\,1}^2 + V_{det\,2}^2}$ , , $V_{det1}$ et $V_{det2}$ étant les valeurs continues desdits premier et deuxième signaux, et
- $I_i$ est une deuxième variable représentant l'amplitude du courant d'injection dans le circuit tertiaire (7 ; 7').

**11.** Compteur selon la revendication 10, **caractérisé en ce que** la deuxième variable $I_i$ est prédéterminée et mémorisée dans le compteur.

**12.** Compteur selon la revendication 10, **caractérisé en ce qu'**il comporte un moyen (20) de mesure de l'amplitude du courant d'injection dans le circuit délivrant une valeur B représentative de l'amplitude d'une tension aux bornes d'une résistance de valeur connue ($R_2$) parcourue par le courant d'injection ($I_{inj}$).

**13.** Compteur selon la revendication 12, **caractérisé en ce qu'**il comporte des moyens (23) de comparaison de la valeur B avec deux valeurs limites respectivement inférieure ($B_{min}$) et supérieure ($B_{max}$) connues du compteur, lesdits moyens (23) de comparaison délivrant un signal d'erreur ($S_{ERR1}$) si la valeur B n'est pas comprise entre ces deux valeurs limites.

**14.** Compteur selon l'une quelconque des revendications 10 à 13, **caractérisé en ce que** ledit moyen (25) de comparaison compare ladite valeur $M_2$ de la mutuelle inductance par rapport à deux valeurs limites mémorisées dans le compteur, une première valeur ($M_{2max}$) correspondant à la valeur de calibration représentative d'un état non saturé de l'élément de blindage (6), et une deuxième valeur ($M_{2sat}$) correspondant à un état de saturation totale de l'élément de blindage (6).

**15.** Compteur selon la revendication 14, **caractérisé en ce que** le moyen (25) de comparaison génère un signal d'alerte ($S_{ALERT}$) dès lors que ladite valeur $M_2$ de la mutuelle inductance est située dans un intervalle prédéfini situé entre lesdites première et deuxième valeurs.

**16.** Compteur selon la revendication 15, **caractérisé en ce que** le moyen (25) de comparaison ne génère ledit signal d'alerte ($S_{ALERT}$) que dans la mesure où ladite valeur $M_2$ est stable durant plusieurs secondes.

**17.** Compteur selon l'une quelconque des revendications 15 et 16, **caractérisé en ce que** ledit signal d'alerte ($S_{ALERT}$) est généré à destination d'un journal d'enregistrement des évènements (26) du compteur, et/ou d'un dispositif d'affichage du compteur permettant de visualiser l'alerte depuis l'extérieur du compteur.

**18.** Compteur selon l'une quelconque des revendications 14 à 17, **caractérisé en ce que** ledit moyen (25) de comparaison génère en outre un signal d'erreur ($S_{ERR2}$) dans le cas où ladite valeur $M_2$ de la mutuelle inductance n'est pas comprise entre lesdites première et deuxième valeurs.

**19.** Compteur selon l'une quelconque des revendications 8 à 18, **caractérisé en ce qu'**il comporte en outre un module (27) de correction permettant de recalculer l'énergie totale réellement consommée par le compteur lorsqu'une fraude a été détectée, à partir de la mesure de la valeur représentative de la mutuelle inductance ($M_2$) entre le circuit tertiaire (7 ; 7') et le circuit secondaire (40).

**20.** Compteur selon l'une quelconque des revendications 8 à 19, **caractérisé en ce qu'**il comporte une pluralité de capteurs (1 ; 1') de mesure inductifs associés chacun à une phase du compteur et **en ce que** les circuits tertiaires correspondant à l'ensemble des capteurs sont connectés en série dans une unique boucle de courant parcourue par ledit courant d'injection ($I_{inj}$).

**Claims**

1. A sensor (1; 1') for measuring inductive type current comprising a primary circuit (3; 3') designed to be traversed by an alternating current to be measured, a secondary circuit (40) magnetically coupled in air with the primary circuit (3; 3') and a shielding element (6) for magnetically isolating the assembly formed by the primary circuit (3; 3') and the secondary circuit (40), and a means (7, 7') for measuring the saturation state of the shielding element (6), so as to detect any fraud through use of a permanent magnet, **characterized in that** said measuring means comprises a winding forming a tertiary circuit (7; 7') between the secondary circuit (40) and the shielding element (6), and designed to be traversed by an injection current ($I_{INJ}$) with a frequency ($f_i$), fixed and different from the fundamental and harmonic frequencies of the current to be measured.

2. The sensor (1; 1') according to claim 1, **characterized in that** the tertiary circuit (7; 7') has a shape similar to that of the primary circuit (3; 3') so as to obtain, on one hand, a mutual inductance ($M_2$) between the tertiary circuit (7; 7') and the secondary circuit (40) very close to the mutual inductance ($M_1$) between the primary circuit (3; 3') and the secondary circuit (40) and, on the other hand, a negligent mutual inductance ($M_3$) between the primary circuit (3; 3') and the tertiary circuit (7; 7').

3. The sensor (1) according to claim 2, **characterized in that** the primary circuit (3) is a generally U-shaped linear conductor, **in that** the secondary circuit (40) is a multi-turn coil centered inside the U, and **in that** the tertiary circuit (7) is an open loop formed by a generally U-shaped continuous conductor track, certain sections (70, 71) of the track corresponding to an inlet (E) and outlet (S) of the tertiary circuit (7) extending in a first plane (80) parallel to the plane of the primary circuit (3), at least one section (72) extending in a second plane (81) parallel to the first plane and arranged symmetrically in relation to the plane of the primary circuit and symmetrically inside the shielding element (6).

4. The sensor (1') according to claim 2, **characterized in that** the primary circuit (3') is a multi-turn coil, and **in that** the tertiary circuit (7') is a continuous conductor track, certain sections (70', 72') of the track corresponding to an inlet (E) and an outlet (S) of the tertiary circuit (7') extending in a first plane (80) parallel to the plane of the primary circuit (3'), at least one section (71') extending in a second plane (81) parallel to the first plane and arranged symmetrically in relation to the plane of the primary circuit and symmetrically inside the shielding element (6), the sections (70', 71', 72') placed opposite the multi-turn coil also being in the form of an arc of a circle.

5. The sensor (1; 1') according to any one of claims 3 and 4, **characterized in that** said tertiary circuit (7; 7') is arranged inside the sensor (1; 1') such that the inlet (E) and the outlet (S) of the tertiary circuit (7; 7') are opposite the entry and exit of the primary circuit (3; 3').

6. The sensor (1; 1') according to any one of claims 3 to 5, **characterized in that** the conductor track forming the tertiary circuit (7; 7') is etched on a flexible printed circuit support (8).

7. The sensor (1; 1') according to any one of claims 1 to 6, **characterized in that** the shielding element (6) serves to maintain the primary, secondary and tertiary circuits of the sensor.

8. An electrical energy meter comprising at least one inductive type electricity measuring sensor (1; 1') according to claim 1, **characterized in that** said measuring means also include, at the sensor, generating means (10, 90) for delivering said injection current (IINJ), means (17-19, 21, 22) for measuring a representative value of the mutual inductance (M2) between the tertiary circuit (7; 7') and the secondary circuit (40), and a means (25) for comparing the measured value with at least one calibrating value (M2max), a state of partial or total saturation of the shielding element which can be deduced when the measured value is less than the calibrating value.

9. The meter according to claim 8, **characterized in that** the generating means (10, 90) deliver an injection current ($I_{INJ}$) in triangular wave form, and **in that** means (17-19, 21, 22) for measuring a representative value of the mutual inductance ($M_2$) between the tertiary circuit (7; 7') and the secondary circuit (40) include a synchronous detector (17) delivering a first signal ($V_{det1}$) and a second signal ($V_{det2}$) resulting from the multiplication of the output signal (Vs) from the sensor (1; 1') by a first sinusoidal signal and by a second co-sinusoidal signal to the frequency ($f_i$) of the injection current ($I_{INJ}$), respectively, and filtering means (18) delivering the continuous values of said first and second signals ($V_{det1}$, $V_{det2}$).

10. The meter according to claim 9, **characterized in that** said means (17-19, 21, 22) for measuring a representative value of the mutual inductance ($M_2$) between the tertiary circuit (7; 7') and the secondary circuit (40) also include an extraction module (22) calculating the value $M_2$ of said mutual according to the relationship

$$M_2 = \frac{A}{2\pi I_i f_i}$$

in which:

- $f_i$ is the frequency of the injection current;

- A is a first variable such that $A = 2\sqrt{V_{det1}^2 + V_{det2}^2}$ , $V_{det1}$ and $V_{det2}$ being the continuous values of said first and second signals, and

- $I_i$ is a second variable representing the amplitude of the injection current in the tertiary circuit (7; 7').

11. The meter according to claim 10, **characterized in that** the second variable $I_i$ is predetermined and stored in the meter.

12. The meter according to claim 10, **characterized in that** it includes a means (20) for measuring the amplitude of the injection current in the circuit delivering a value B representative of the amplitude of a voltage at the terminals of a known resistance value ($R_2$) traversed by the injection current ($I_{INJ}$).

13. The meter according to claim 12, **characterized in that** it includes means (23) for comparing the value B with two respective known lower ($B_{min}$) and upper ($B_{max}$) limiting values of the meter, said comparison means (23) delivering an error signal ($S_{ERR1}$) if the value B is not between said two limiting values.

14. The meter according to any one of claims 10 to 13, **characterized in that** said comparison means (25) compares said value $M_2$ of the mutual inductance to two limiting values stored in the meter, a first value ($M_{2max}$) corresponding to the calibrating value representative of an unsaturated state of the shielding element (6), and a second value ($M_{2sat}$) corresponding to a state of total saturation of the shielding element (6).

15. The meter according to claim 14, **characterized in that** the comparison means (25) generates an alert signal ($S_{ALERT}$) when said mutual inductance value $M_2$ is situated in a predefined interval situated between said first and second values.

16. The meter according to claim 15, **characterized in that** the comparison means (25) only generates said alert signal ($S_{ALERT}$) inasmuch as said value $M_2$ is stable for several seconds.

17. The meter according to any one of claims 15 and 16, **characterized in that** said alert signal ($S_{ALERT}$) is generated intended for an event log (26) of the meter, and/or a display device of the meter making it possible to view the alert from the outside of the meter.

18. The meter according to any one of claims 14 to 17, **characterized in that** said comparison means (25) also generates an error signal ($S_{ERR2}$) in the event said mutual inductance value $M_2$ is not between said first and second values.

19. The meter according to any one of claims 8 to 18, **characterized in that** it also includes a correction module (27) making it possible to recalculate the total energy actually consumed by the meter when a fraud has been detected, from the measurement of the representative value of the mutual inductance ($M_2$) between the tertiary circuit (7; 7') and the secondary circuit (40).

20. The meter according to any one of claims 8 to 19, **characterized in that** it includes a plurality of inductive type measuring sensors (1; 1') each associated with a phase of the meter and **in that** the tertiary circuits corresponding to all of the sensors are series-connected in a single current loop traversed by said injection current ($I_{INJ}$).

**Patentansprüche**

1. Strommesssensor (1; 1') induktiver Art, umfassend einen Primärkreis (3; 3'), der zum Durchfluss eines zu messenden Wechselstroms gedacht ist, einen Sekundärkreis (40), der mit dem Primärkreis (3; 3') magnetisch in Luft gekoppelt ist, und ein Abschirmelement (6) zur magnetischen Isolierung des aus dem Primärkreis (3; 3') und dem Sekundärkreis (40) gebildeten Ganzen, und ein Mittel (7; 7') zum Messen eines Sättigungszustands des Abschirmelements (6), um eine eventuelle Fälschung durch Verwendung eines Dauermagnets zu erfassen, **dadurch gekennzeichnet, dass** das Messmittel eine Wicklung umfasst, die einen Tertiärkreis (7; 7') bildet, der zwischen dem Sekundärkreis (40) und dem Abschirmelement (6) eingefügt wird und zum Durchfluss eines Injektionsstroms ($I_{INJ}$) mit einer Festfrequenz ($f_i$), die sich von Grund- und Oberschwingungsfrequenzen des zu messenden Stroms unterscheidet, gedacht ist.

2. Sensor (1; 1') nach Anspruch 1, **dadurch gekennzeichnet, dass** der Tertiärkreis (7; 7') eine ähnliche Form aufweist wie die des Primärkreises (3; 3'), um einerseits eine Gegeninduktivität ($M_2$) zwischen dem Tertiärkreis (7; 7') und dem Sekundärkreis (40), die sehr nah an der Gegeninduktivität ($M_1$) zwischen dem Primärkreis (3; 3') und dem Sekundärkreis (40) liegt, und andererseits zwischen Primärkreis (3; 3') und Tertiärkreis (7; 7') eine unbedeutende Gegeninduktivität (M3) zu erzielen.

3. Sensor (1) nach Anspruch 2, **dadurch gekennzeichnet, dass** der Primärkreis (3) ein im Allgemeinen U-förmiger Linearleiter ist, dass der Sekundärkreis (40) eine Spule mit mehreren Windungen ist, die im Innern des U zentriert ist, und dass der Tertiärkreis (7) eine offene Schleife ist, die von einer im Allgemeinen U-förmigen durchgehenden Leiterbahn gebildet wird, wobei bestimmte Teilstücke (70, 71) der Bahn einem Eingang (E) und einem Ausgang (S) des Tertiärkreises (7) entsprechen, der sich in einer ersten Ebene (80) erstreckt, die zu der Ebene des Primärkreises (3) parallel ist, wobei sich mindestens ein Teilstück (72) in einer zweiten Ebene (81) erstreckt, die zu der ersten Ebene parallel ist und im Verhältnis zu der Ebene des Primärkreises und symmetrisch zum Innern des Abschirmelements (6) angeordnet ist.

4. Sensor (1') nach Anspruch 2, **dadurch gekennzeichnet, dass** der Primärkreis (3') eine Spule mit mehreren Windungen ist, und dass der Tertiärkreis (7') eine durchgehende Leiterbahn ist, wobei bestimmte Bahnteilstücke (70', 72') einem Eingang (E) und einem Ausgang (S) des Tertiärkreises (7') entsprechen, der sich in einer ersten Ebene (80) parallel zu der Ebene des Primärkreises (3') erstreckt, wobei sich mindestens ein Teilstück (71') in einer zweiten Ebene (81) parallel zur ersten Ebene erstreckt und symmetrisch im Verhältnis zur Ebene des Primärkreises und symmetrisch zum Innern des Abschirmelements (6) angeordnet ist, wobei die Teilstücke (70', 71', 72'), die gegenüber der Spule mit mehreren Windungen angeordnet sind, ferner kreisbogenförmig sind.

5. Sensor (1; 1') nach einem der Ansprüche 3 und 4, **dadurch gekennzeichnet, dass** der Tertiärkreis (7; 7') im Innern des Sensors (1; 1') angeordnet ist, so dass der Eingang (E) und der Ausgang (S) des Tertiärkreises (7; 7') dem Eingang und dem Ausgang des Primärkreises (3; 3') gegenüberliegen.

6. Sensor (1; 1') nach einem der Ansprüche 3 bis 5, **dadurch gekennzeichnet, dass** die Leiterbahn, die den Tertiärkreis (7; 7') bildet, auf einem flexiblen Träger (8) für gedruckte Schaltungen geätzt ist.

7. Sensor (1; 1') nach einem der Ansprüche 1 bis 6, **dadurch gekennzeichnet, dass** das Abschirmelement (6) zur Halterung für die Primär-, Sekundär- und Tertiärkreise des Sensors dient.

8. Elektrischer Energiezähler, umfassend mindestens einen Strommesssensor (1; 1') induktiver Art nach Anspruch 1, **dadurch gekennzeichnet, dass** die Messmittel ferner am Zähler Erzeugungsmittel (10, 90), um den Injektionsstrom ($I_{INJ}$) abzugeben, Mittel (17 bis 19, 21, 22) zum Messen eines Wertes, der die Gegeninduktivität ($M_2$) zwischen dem Tertiärkreis (7; 7') und dem Sekundärkreis (40) darstellt, und ein Mittel (25) zum Vergleichen des gemessenen Wertes mit mindestens einem Kalibrierwert ($M_{2max}$) umfassen, wobei ein teilweiser oder vollständiger Sättigungszustand des Abschirmelements abgeleitet werden kann, sobald der gemessene Wert geringer als der Kalibrierwert ist.

9. Zähler nach Anspruch 8, **dadurch gekennzeichnet, dass** die Erzeugungsmittel (10, 90) einen Injektionsstrom ($I_{INJ}$) in Form einer Dreieckswelle abgeben, und dass Mittel (17 bis 19, 21, 22) zum Messen eines Wertes, der für die

Gegeninduktivität ($M_2$) zwischen dem Tertiärkreis (7; 7') und dem Sekundärkreis (40) repräsentativ ist, einen Synchrondetektor (17), der ein erstes Signal ($V_{det1}$) und ein zweites Signal ($V_{det2}$) abgibt, die sich aus der Multiplikation des Ausgangssignals (Vs) des Sensors (1; 1') jeweils mit einem ersten Sinussignal und mit einem zweiten Cosinussignal auf der Frequenz ($f_i$) des Injektionsstroms ($I_{INJ}$) ergeben, und Filtermittel (18), welche die Dauerwerte der ersten und zweiten Signale ($V_{det1}$, $V_{det2}$) abgeben, umfassen.

**10.** Zähler nach Anspruch 9, **dadurch gekennzeichnet, dass** die Mittel (17 bis 19, 21, 22) zum Messen eines Wertes, der für die Gegeninduktivität ($M_2$) zwischen dem Tertiärkreis (7; 7') und dem Sekundärkreis (40) repräsentativ ist, ferner ein Extraktionsmodul (22) umfassen, das den Wert $M_2$ der Gegeninduktivität nach folgender Beziehung berechnen

$$M_2 = \frac{A}{2\pi I_i f_i}$$

wobei:

- $f_i$ die Frequenz des Injektionsstroms ist;

- A eine erste Variable ist, so dass $A = 2\sqrt{V_{det1}^2\, V_{det2}^2}$, wobei $V_{det1}$ und $V_{det2}$ die Dauerwerte der ersten und zweiten Signale sind, und

- $I_i$ eine zweite Variable ist, welche die Amplitude des Injektionsstroms im Tertiärkreis (7; 7') darstellt.

**11.** Zähler nach Anspruch 10, **dadurch gekennzeichnet, dass** die zweite Variable $I_i$ vorherbestimmt und in dem Zähler gespeichert ist.

**12.** Zähler nach Anspruch 10, **dadurch gekennzeichnet, dass** er ein Mittel (20) zum Messen der Amplitude des Injektionsstroms in dem Schaltkreis umfasst, der einen Wert B abgibt, der für die Amplitude einer Klemmenspannung eines Widerstands mit bekanntem Wert ($R_2$) repräsentativ ist, durch den der Injektionsstrom ($I_{inj}$) fließt.

**13.** Zähler nach Anspruch 12, **dadurch gekennzeichnet, dass** er Mittel (23) zum Vergleichen des Wertes B mit zwei bekannten, jeweils unteren ($B_{min}$) und oberen ($B_{max}$) Grenzwerten des Zählers umfasst, wobei die Vergleichsmittel (23) ein Fehlersignal ($S_{ERR1}$) abgeben, wenn der Wert B nicht zwischen diesen beiden Grenzwerten liegt.

**14.** Zähler nach einem der Ansprüche 10 bis 13, **dadurch gekennzeichnet, dass** das Vergleichsmittel (25) den Wert $M_2$ der Gegeninduktivität mit Bezug auf zwei Grenzwerte vergleicht, die in dem Zähler gespeichert sind, wobei ein erster Wert ($M_{2max}$) dem Kalibrierwert entspricht, der für einen nicht gesättigten Zustand des Abschirmelements (6) repräsentativ ist, und ein zweiter Wert ($M_{2sat}$) einem vollständigen Sättigungswert des Abschirmelements (6) entspricht.

**15.** Zähler nach Anspruch 14, **dadurch gekennzeichnet, dass** das Vergleichsmittel (25) ein Warnsignal ($S_{ALERT}$) erzeugt, sobald der Wert $M_2$ der Gegeninduktivität in einem vorgegebenen Intervall liegt, das zwischen den ersten und zweiten Werten liegt.

**16.** Zähler nach Anspruch 15, **dadurch gekennzeichnet, dass** das Vergleichsmittel (25) das Warnsignal ($S_{ALERT}$) nur erzeugt, wenn der Wert $M_2$ mehrere Sekunden lang gleich bleibt.

**17.** Zähler nach einem der Ansprüche 15 und 16, **dadurch gekennzeichnet, dass** das Warnsignal ($S_{ALERT}$) für ein Protokoll zur Aufzeichnung der Ereignisse (26) des Zählers und/oder für eine Anzeigevorrichtung des Zählers, die es ermöglicht, die Warnung außerhalb des Zählers zu sehen, erzeugt wird.

**18.** Zähler nach einem der Ansprüche 14 bis 17, **dadurch gekennzeichnet, dass** das Vergleichsmittel (25) ferner ein Fehlersignal ($S_{ERR2}$) erzeugt, falls der Wert $M_2$ der Gegeninduktivität nicht zwischen den ersten und zweiten Werten liegt.

**19.** Zähler nach einem der Ansprüche 8 bis 18, **dadurch gekennzeichnet, dass** er ferner ein Korrekturmodul (27) umfasst, das es ermöglicht, die Gesamtenergie, die tatsächlich von dem Zähler verbraucht wurde, wenn eine Fälschung erfasst wurde, ausgehend von der Messung des Wertes, der für die Gegeninduktivität ($M_2$) zwischen dem Tertiärkreis (7; 7') und dem Sekundärkreis (40) repräsentativ ist, neu zu berechnen.

**20.** Zähler nach einem der Ansprüche 8 bis 19, **dadurch gekennzeichnet, dass** er eine Vielzahl von induktiven Messsensoren (1; 1') umfasst, die jeweils mit einer Phase des Zählers verbunden sind, und dass die Tertiärkreise allen Sensoren entsprechen, die in Reihe in einer einzigen Stromschleife geschaltet sind, durch die der Injektionsstrom ($I_{inj}$) fließt.

**FIG. 1a**

**FIG. 1b**

**FIG. 1c**

72

81

8

74

73

80

7

71

70

S

E

$I_{INJ}$

## FIG. 2

7

3

I

$I_{INJ}$

8

## FIG. 3

FIG. 4a

FIG. 4b

FIG. 4c

71'

8

81

72'

70'

80

S

E

$I_{INJ}$

## FIG. 5

$I_{INJ}$

70'

72'

8'

I

3'

## FIG. 6

Correction Energie
$W_{cor} = W(M_{1max}/M_1(x))$ — 27

Journal evènements — 26

25 — Comparaison $M_2$ / $M_{2max}$, $M_{2sat}$

$S_{ALERT}$

$S_{ERR2}$ Journal erreurs — 24

22 — Extraction $M_2$

$S_{ERR1}$ — 23

Comparaison B / Bmin, Bmax

$A = 2\sqrt{V_{det1}^2 + V_{det2}^2}$ — 19

A

Registre — 16

B — 21

$B = R_2 I_{INJ}$

W

15 — U x I et calcul énergie moyenne W

Filtres passe bas — 18

$V_{det1}$, $V_{det2}$

14 — Intégration

Détecteur Synchrone

$f_i$

Générateur $f_i$

Mesure $I_{INJ}$ — 20

17

90

9

CAN — 13

Prélèvement U — 11

Prélèvement I — 12

R1    R2

S    E

$I_{INJ}$

Mise en forme triangulaire — 10

I

1,1'

**FIG. 7**

I_{INJ}

1, 1'

1, 1'

Phase 1          Phase 2          Phase 3

# FIG. 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2800167

- GB 2409528 A